# EUROPÄISCHE PATENTSCHRIFT

(11) **EP 1 082 815 B1**
(45) Veröffentlichungstag und Bekanntmachung des Hinweises auf die Patenterteilung: **10.05.2006**
(21) Anmeldenummer: 99924740.6
(22) Anmeldetag: 01.04.1999
(51) Int. Cl.: H03K 17/0814

(54) **SMARTPOWER-BAUELEMENT**
SMART POWER COMPONENT
COMPOSANT DE PUISSANCE INTELLIGENT

(30) Priorität: 28.05.1998 DE 19823768
(43) Veröffentlichungstag der Anmeldung: 14.03.2001
(73) Patentinhaber: ROBERT BOSCH GMBH, 70442 Stuttgart (DE)
(72) Erfinder: TOPP, Rainer, D-72768 Reutlingen (DE); TROELENBERG, Wolfgang, D-72764 Reutlingen (DE)
(86) Internationale Anmeldenummer: PCT/DE1999/000986
(87) Internationale Veröffentlichungsnummer: WO 1999/062174

(56) Entgegenhaltungen:
- EP-A- 0 808 025
- WO-A-96/12346
- US-A- 5 142 171

## Beschreibung

Die Erfindung geht aus von einem Leistungsbauelement nach der Gattung der beiden nebengeordneten Ansprüche. Leistungsbauelemente mit einem Stellglied, dem ein Meßelement, das als Stromerfassungselement arbeitet, benachbart ist, sind in Form von Sensefet-Transistoren bereits bekannt. Beispielsweise zeigt die Druckschrift US-PS 5 142 171 ein solches Leistungsbauelement. Das Meßelement steht mit einem ersten Sourceanschluß mit dem des Stellglied in Verbindung und mit einem zweiten Sourceanschluß mit dem Meßelement. Zwischen dem ersten und dem zweiten Sourceanschluß ist ein Mittel zum Schutz vor parasitären Strömen geschaltet ist, so daß bei einem negativen Potential am ersten Sourceanschluß das Mittel in einen leitenden Zustand versetzt wird.

### Vorteile der Erfindung

Die erfindungsgemäßen Leistungsbauelemente mit den kennzeichnenden Merkmalen der nebengeordneten Patentansprüche haben demgegenüber den Vorteil, einen sichern und zuverlässigen Betrieb auch bei hohen Strömen durch das Stellglied zu gewährleisten sowie einen Schutz vor Ausfallgefahr zu bieten.

Durch die in den abhängigen Ansprüchen aufgeführten Maßnahmen sind vorteilhafte Weiterbildungen und Verbesserungen des im Hauptanspruch angegebenen Leistungsbauelements möglich. Insbesondere bei Smartpower-Bauelementen wie Sensefet-Transistoren (beispielsweise in DMOS-Ausführung) oder bei IGBT-Transistoren mit integriertem Senseelement wird ein sicherer Schutz vor Überspannung und Durchbrüchen zwischen Sensezelle und benachbarter DMOS-Zelle gewährleistet. Insbesondere in der Anwendung als Highsideschalter sind kritische Betriebsbedingungen wie beispielsweise Masse- und/oder Battierieabriß, ISO-Pulse (Störpulse aus dem Versorgungsnetz) oder bei induktiven Lasten bzw. Kabelinduktivitäten ohne Ausfallgefahr des Leistungsbauelements überstehbar. Darüber hinaus erweist es sich als vorteilhaft, daß im Normalbetrieb keine Beeinträchtigung der Stromerfassung durch das Senseelement in Folge des vorgesehenen Mittels erfolgt. Darüber hinaus ist die Anordnung monolithisch integrierbar.

Verhindert das Mittel ein Aktivieren vorhandener parasitärer Bipolar-Transistoren beispielsweise durch Verhindern des Aufschwemmens des Basispotentials, so wird die Gefahr eines zweiten Durchbruchs mit folgender Aufschmelzung sicher abgewendet.

Weitere Vorteile ergeben sich aus den in den weiteren Unteransprüchen genannten Merkmale.

### Zeichnung

Ausführungsbeispiel der Erfindung sind in der Zeichnung dargestellt und in der nachfolgenden Beschreibung näher erläutert. Es zeigen Figur 1 einen Sensefet-Transistor in Querschnittsseitenansicht, Figur 2 ein erstes Ausführungsbeispiel, Figur 3 ein zweites nicht beanspruchtes Ausführungsbeispiel, Figur 4 ein drittes Ausführungsbeispiel und Figur 5 ein viertes und ein fünftes Ausführungsbeispiel.

### Beschreibung der Ausführungsbeispiele

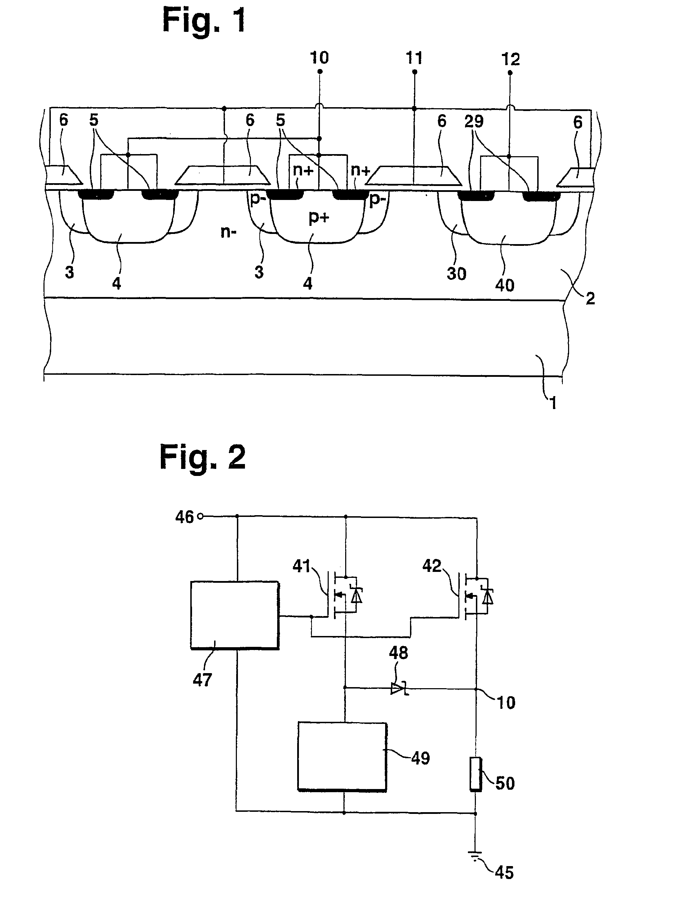

Figur 1 zeigt einen Transistor mit Senseelement in Querschnittsseitenansicht. Auf einem p-dotierten Substrat 1 ist eine schwach n-dotierte Halbleiterschicht 2 angeordnet. In die Halbleiterschicht 2 sind schwach p-dotierte Gebiete 3 angeordnet, die voneinander durch Bereiche der Halbleiterschicht 2 getrennt sind. In der Mitte der Gebiete 3 ist jeweils ein stark p-dotiertes Gebiet 4 angeordnet, das von der Oberfläche des Halbleiterbauelements bis in eine Tiefe reicht, in der das Gebiet 4 jeweils direkt mit der Halbleiterschicht 2 in Kontakt steht. In die stark p-dotierten Gebiete 4 sind stark n-dotierte Gebiete 5 randständig eingebracht, die am Rand der stark p-dotierten Gebiete 4 jeweils etwas in das schwach p-dotierte Gebiet 3 hineinragen. Ebenfalls in die Halbleiterschicht 2 eingebracht ist ein schwach p-dotiertes Gebiet 30, analog zum Gebiet 5. Analog zum Gebiet 4 ist in das schwach p-dotierte Gebiet 30 ein stark p-dotiertes Gebiet 40 eingebracht; analog zu den stark n-dotierten Gebieten 5 sind in das stark p-dotierte Gebiet 40 stark n-dotierte Gebiet 29 eingebracht. Oberhalb der Bereiche der Halbleiterschicht 2, die bis an die Oberfläche des Halbleiterbauelements ragen, sind, durch eine Isolatorschicht von der Halbleiteroberfläche isoliert, Gateelektroden 6 angeordnet. Die Gateelektroden 6 sind miteinander elektrisch verbunden und über den Gateanschluß 11 elektrisch kontaktierbar. Die stark n-dotierten Gebiete 5 und die stark p-dotierten Gebiete 4 sind miteinander elektrisch verbunden und gemeinsam über den Source-/Lastanschluß 10 elektrisch kontaktierbar. Die Gebiete 40 und 29 sind ebenfalls elektrisch miteinander verbunden und über den Senseanschluß 12 elektrisch kontaktierbar. In der Figur 1 sind Oxidschichten und erforderliche Metallisierungen an der Oberfläche des Halbleiterbauelements aus Gründen der Einfachheit der Darstellung nicht eingezeichnet. Ist das Bauelement nach Figur 1 als DMOS-Leistungstransistor ausgebildet, so ist beispielsweise noch ein stark n-dotiertes Draingebiet in die schwach n-dotierte Halbleiterschicht 2 eingebracht. Dieses Draingebiet ist in Figur 1 nicht eingezeichnet. Dieses Draingebiet ist über einen ebenfalls nicht eingezeichneten vorderseitigen Drainanschluß elektrisch kontaktierbar und stellt neben dem Lastanschluß 10, dem Gateanschluß 11 und dem Senseanschluß 12 den vierten Anschluß eines Sensefet-Transistors dar.

Das p-Gebiet 3, das p-Gebiet 30 und der zwischen diesen beiden p-Gebieten liegende Bereich der Halbleiterschicht 2 bildet einen parasitären PMOS-Transistor. Dieser parasitäre PMOS-Transistor hat bei einem Gatepotential, das niedriger ist als das Potential am Senseanschluß 12, eine Schwellenspannung zwischen Sourceanschluß 10 und Senseanschluß 12, die beispielsweise 4 Volt beträgt. Liegt dann das Gebiet 30, das das Sourcegebiet des parasitären PMOS-Transistors darstellt, auf einen Potential, das mindestens 4 Volt über dem Potential des p-Gebiets 3 liegt, so wird in der Halbleiterschicht 2 ein parasitärer p-Kanal aktiviert. Der parasitäre PMOS-Transistor schiebt Strom in das Gebiet 3 der benachbarten DMOS-Zelle, die zugleich als Basis eines vertikalen npn-Bipolar-Transistors wirkt. Dieser parasitäre npn-Transistor wird durch die Gebiete 5, 3/4 und die Halbleiterschicht 2 gebildet. Im normalen Betriebszustand ein Durchschalten dieses parasitären npn-Bipolar-Transistors durch einen Kurzschluß zwischen dem stark n-dotierten Gebiet 5 und stark p-dotierten Gebiet 4 wirkungsvoll unterdrückt. Der Strom des parasitären PMOS-Transistors läßt das Basisgebiet des parasitären Bipolar-Transistors aber im Potential aufschwemmen, so daß der npn-Bipolar-Transistor aktiviert wird und die Gefahr eines zweiten Durchbruchs mit Aufschmelzung besteht.

Figur 2 zeigt einen Sensefet-Transistor 41, 42 einem Senseelement 41 und einem Stellglied 42, das beispielsweise in DMOS-Technik ausgeführt ist. Die Gate-Elektroden von Senseelement 41 und Stellglied 42 sind mit einer Ansteuerschaltung 47 verbunden, die ihrerseits zur Energieversorgung mit dem Masseanschluß 45 einerseits und mit der Spannungsversorgung 46 andererseits verbunden ist.

Die Spannungsversorgung 46 ist ebenfalls mit den Drainanschlüssen von Senseelement und Stellglied verbunden. Zwischen Masse 45 und dem Sourceanschluß des Senseelements 41 ist eine Auswerteschaltung 49 geschaltet. Zwischen dem Sourceanschluß 10 des Stellglieds 42 und Masse 45 ist eine induktive Last 50 angeschlossen. Zwischen dem Sourceanschluß 10 des Stellglieds 42 und dem Sourceanschluß des Senseelements 41 ist eine Schutzdiode 48 geschaltet, wobei der Minuspol der Schutzdiode mit dem Sourceanschluß 10 des Stellglieds 42 verbunden ist.

Die (extern ansteuerbare) Ansteuerschaltung 47 regelt den Strom durch das Stellglied 42. Die Auswerteschaltung 49 wertet den Strom durch das Senseelement 41 aus, das als Stromerfassungselement dient. Die Auswerteschaltung 49 ist je nach Anwendung mit anderen elektronischen Schaltungen oder mit der Ansteuerschaltung 47 verbunden, um die Information über die Größe des Laststroms durch das Stellglied 42 den anderen Schaltungsteilen bzw. der Ansteuerschaltung 47 zur Verfügung zu stellen. Erfolgt an der induktiven Last 50 ein Masseabriß oder ein Abriß der Spannungsversorgung, so wird aufgrund der magnetischen Induktion das Potential des Sourceanschlusses 10 negativ. Dadurch wird die Schutzdiode 48 in den leitenden Zustand versetzt, wodurch garantiert wird, daß der Sourceanschluß des Senseelements 41 ein Potential hat, das lediglich eine Flußspannung über dem Potential des Sourceanschlusses 10 liegt. Dadurch wird wirksam ein Aktivieren des parasitären PMOS-Transistors unterdrückt. Im Normalbetrieb läßt die Diodee hingegen die Funktion des Senseelements 41 unbeeinflußt, da im Normalbetrieb das Schutzelement 48 in

Sperrichtung geschaltet ist.

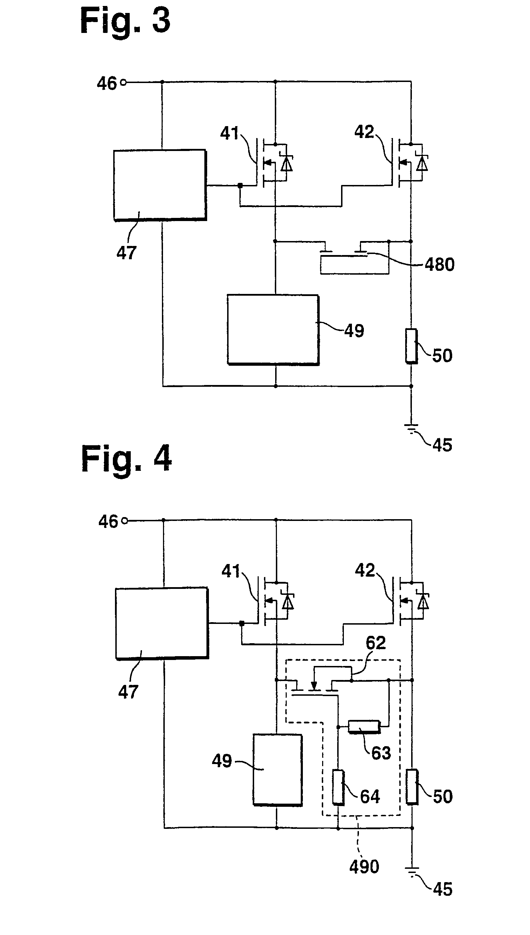

Figur 3 zeigt ein weiteres nicht beanspruchtes Ausführungsbeispiel, in dem gleiche Bestandteile mit gleichem Bezugszeichen wie in Figur 2 bezeichnet sind und nicht nochmals beschrieben werden.

Statt der Schutzdiode 48 in Figur 2 ist ein PMOS-Transistor 480 mit den Sourceanschlüssen von Senseelement 41 und Stellglied 42 verbunden, wobei der Transistor als Diode geschaltet ist derart, daß bei negativem Potential des Sourceanschlusses 10 des Stellglieds 42 der PMOS-Transistor durchschaltet.

Figur 4 zeigt ein weiteres Ausführungsbeispiel, bei dem anstelle eines Schutzelementes 48 eine Schutzbeschaltung 490 angeordnet ist. Diese Schutzbeschaltung 490 weist einen NMOS-Transistor 62, einen ersten Widerstand 63 und einen zweiten Widerstand 64 auf. Der erste Widerstand 63 ist mit dem Sourceanschluß des Stellglieds 42 verbunden. Der erste Widerstand 63 ist ferner mit dem zweiten Widerstand 64 verbunden. Der zweite Widerstand 64 ist mit Masse 45 verbunden. Erster wie zweiter Widerstand sind an der Gateelektrode des NMOS-Transistors 62 angeschlossen. Der Sourceanschluß des Transistors 62 ist mit dem Sourceanschluß 20 des Stellglieds 42 verbunden. Der Drainanschluß des Transistors 62 ist mit dem Sourceanschluß des Senseelements 41 verbunden.

Der NMOS-Transistor 62 schaltet bei negativem Sourcepotential des Stellglieds 42 durch. Der Betrag des negativen Potentials, bei dem der NMOS-Transistor 62 durchschaltet, kann über die Widerstandswerte des ersten Widerstands 63 und des zweiten Widerstsands 64 eingestellt werden.

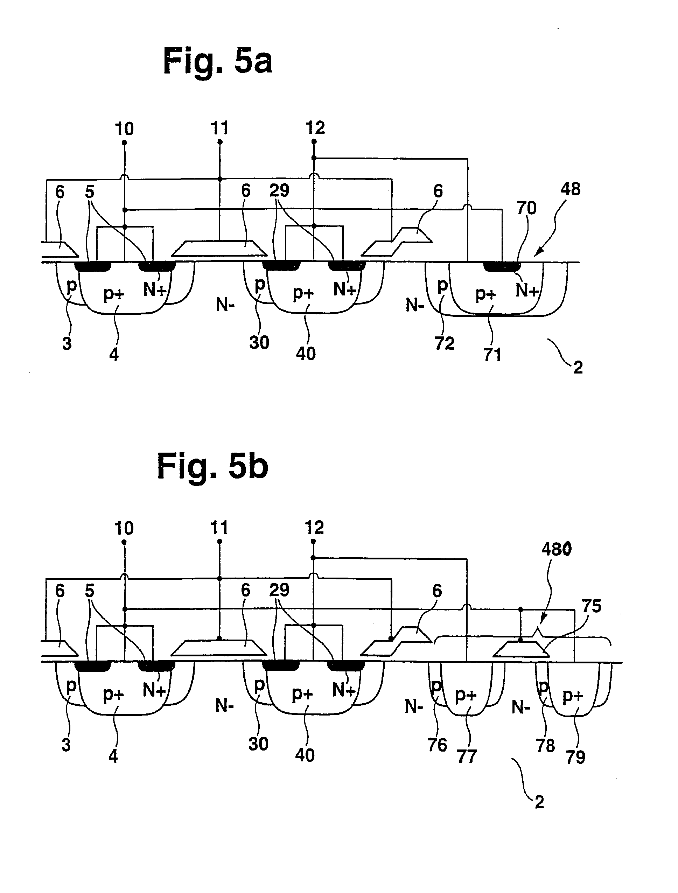

Figur 5a zeigt eine Querschnittsseitenansicht eines Bauelements nach Figur 1 mit einer integrierten Schutzdiode 48. Gleiche Bezugszeigen wie in Figur 1 werden hier nicht nochmals beschrieben. Die Schutzdiode 48 weist ein in die Halbleiterschicht 2 eingebrachtes schwach p-dotiertes Gebiet 72 auf, in das wiederum, umgeben vom p-dotierten Gebiet 72, ein stark p-dotiertes Gebiet 71 eingebracht ist. In das stark p-dotierte Gebiet 71 wiederum ist ein stark n-dotiertes Gebiet 70 eingebracht. Das stark n-dotierte Gebiet 70 ist elektrisch mit dem Sourceanschluß 10 verbunden, das stark p-dotierte Gebiet 71 ist mit den Senseanschluß 12 verbunden. Ebenso, wie in Figur 1 sind elektrische Isolationsschichten sowie Metallisierungen in der Zeichnung zur vereinfachten Darstellung weggelassen. Dadurch erklärt sich auch beispielsweise die Stufe der rechten der drei dargestellten Gateelektroden 6, die mit einer Isolationsschicht unterlegt ist. Figur 5b zeigt ein Leistungsbauelement nach Figur 1 mit einem als PMOS-Transistor ausgestalteten Schutzelement 480. Das Schutzelement 480, das in Nachbarschaft zum Senseelement angeordnet ist, weist zwei in die Halbleiterschicht 2 eingebrachte schwach p-dotierte Gebiete 76 und 78 auf, in die wiederum stark p-dotierte Gebiete 77 und 78 eingebracht sind, die die p-dotierten Gebiete 76 bzw. 79 vollständig durchdringen und direkt mit der Halbleiterschicht 2 in Kontankt stehen. Die Gateelektrode 75 des Schutzelements 480 ist mit dem Sourceanschluß 10 verbunden, das stark p-dotierte Gebiet 77 ist mit dem Senseanschluß 12 verbunden, und das stark p-dotierte Gebiet 79 ist ebenfalls wie die Gateelektrode 75 mit dem Sourceanschluß 10 verbunden.

Figur 5a und b stellen einfache Realisierungen der Schaltungen nach Figur 2 bzw. 3 dar. Zur Realisierung der Schutzelemente 48 bzw. 480 ist kein wesentlicher zusätzlicher Aufwand erforderlich, da die Gebiete 71, 72, 76, 77, 78 und 79 zusammen mit den für das Stellglied und das Senseelement erforderlichen Halbleitergebieten hergestellt werden können. Die Schutzelemente 48 und 480 sind natürlich ebenfalls bei rückseitig kontaktierten, d. h. vertikalen Leistungsbauelementen oder auch IGBT-Bauelementen einsetzbar.

## Patentansprüche

1. Leistungsbauelement mit einem Stellglied (42) und einem benachbarten Meßelement (41), das als Stromerfassungselement für die Größe des Laststroms durch das Stellglied dient, mit einem ersten Sourceanschluß des Stellglieds und einem zweiten Sourceanschluß des Meßelements, wobei der erste Sourceanschluß über eine induktive Last (50) mit Masse verbunden ist und zwischen dem ersten und dem zweiten Sourceanschluß ein Mittel (48) zum Schutz vor parasitären Strömen geschaltet ist, so daß bei einem gegenüber Masse negativen Potential am ersten Sourceanschluß das Mittel in einen leitenden Zustand versetzt wird, **dadurch gekennzeichnet, daß** das Mittel eine Zenerdiode (48) aufweist, deren Anode mit dem zweiten Sourceanschluß und deren Kathode mit dem ersten Sourceanschluß verbunden ist.

2. Leistungsbauelement mit einem Stellglied (42) und einem benachbarten Meßelement (41), das als Stromerfassungselement für die Größe des Laststroms durch das Stellglied dient, mit einem ersten Sourceanschluß des Stellglieds und einem zweiten Sourceanschluß des Meßelements, wobei der erste Sourceanschluß über eine induktive Last (50) mit Masse verbunden ist und zwischen dem ersten und dem zweiten Sourceanschluß ein Mittel (62) zum Schutz vor parasitären Strömen geschaltet ist, so daß bei einem gegenüber Masse negativen Potential am ersten Sourceanschluß das Mittel in einen leitenden Zustand versetzt wird, **dadurch gekennzeichnet, daß** das Mittel eine Schutzschaltung (490) mit mindestens einem Widerstand (63) aufweist, wobei durch die Wahl des Widerstandswerts die Bedingung an den Betrag des negativen Potentials am ersten Sourceanschluß zur Aktivierung der Schutzschaltung einstellbar ist.

3. Bauelement nach Anspruch 1 oder 2, **dadurch gekennzeichnet, daß** es eine Halbleiterschicht (2) eines ersten Leitfähigkeitstyps aufweist, in der ein erstes (3,4) und ein zweites Gebiet (30,40) eines zweiten Leitfähigkeitstyps eingebettet sind, wobei das erste und das zweite Gebiet nebeneinander und voneinander getrennt angeordnet sind und jeweils mindestens ein drittes (5) beziehungsweise viertes Gebiet (29) in das erste beziehungsweise zweite Gebiet eingebettet ist, wobei das erste Gebiet mit dem ersten Anschluß und das zweite Gebiet mit dem zweiten Anschluß verbunden ist, wobei das erste Gebiet, das zweite Gebiet und der zwischen dem ersten und dem zweiten Gebiet liegende Bereich der Halbleiterschicht einen parasitären MOS-Transistor bildet, und daß das Mittel ein Erreichen eines Schwellwerts einer zwischen dem ersten und dem zweiten Anschluß anliegenden Spannung, das zu einer Aktivierung des par+sitären MOS-Transistors führen würde, verhindert.

4. Bauelement nach Anspruch 1, 2 oder 3, **dadurch gekennzeichnet, daß** das erste (3,4) und das dritte (5) Gebiet und die Halbleiterschicht (2) einen parasitären Bipolartransistor bilden, wobei das erste Gebiet mit dem dritten Gebiet kurzgeschlossen ist und die Basis des parasitären Bipolartransistors bildet, und daß das Mittel ein Aktivieren des parasitären Bipolartransistors unterbindet.

5. Bauelement nach Anspruch 3 oder 4, **dadurch gekennzeichnet, daß** das Schutzelement gesperrt ist, solange der Schwellwert nicht erreicht ist.

6. Bauelement nach einem der vorhergehenden Ansprüche, **dadurch gekennzeichnet, daß** es als MOS-Bauelement ausgebildet ist.

7. Bauelement nach einem der Ansprüche 1 bis 5, **dadurch gekennzeichnet, daß** es als IGBT-Bauelement ausgebildet ist.

8. Bauelement nach einem der vorhergehenden Ansprüche, **dadurch gekennzeichnet, daß** das Mittel monolithisch mit dem Stellglied und dem Meßelement integriert ist.

9. Bauelement nach einem der vorhergehenden Ansprüche, **dadurch gekennzeichnet, daß** es ohne Ausfallgefahr zum Schalten einer induktiven Last, insbesondere als Highside-Schalter, einsetzbar ist.

10. Bauelement nach einem der vorhergehenden Ansprüche, **dadurch gekennzeichnet, daß** das Mittel einen ungestörten Betrieb des Meßelements gewährleistet, solange es nicht aktiviert ist.

## Claims

1. Power component having an actuator (42) and an adjacent measuring element (41), which serves as current sensing element for the magnitude of the load current through the actuator, having a first source terminal of the actuator and a second source terminal of the measuring element, the first source terminal being connected to earth via an inductive load (50) and a means (48) for protection from parasitic currents being connected between the first and second source terminals, so that, in the case of a negative potential with respect to earth at the first source terminal, the means is put into a conducting state, **characterized in that** the means has a zener diode (48), the anode of which is connected to the second source terminal and the cathode of which is connected to the first source terminal.

2. Power component having an actuator (42) and an adjacent measuring element (41), which serves as current sensing element for the magnitude of the load current through the actuator, having a first source terminal of the actuator and a second source terminal of the measuring element, the first source terminal being connected to earth via an inductive load (50) and a means (62) for protection from parasitic currents being connected between the first and second source terminals, so that, in the case of a negative potential with respect to earth at the first source terminal, the means is put into a conducting state, **characterized in that** the means has a protective circuit (490) having at least one resistor (63), in which case, through the choice of the resistance, it is possible to set the condition on the magnitude of the negative potential at the first source terminal for the activation of the protective circuit.

3. Component according to Claim 1 or 2, **characterized in that** it has a semiconductor layer (2) of a first conductivity type in which a first (3, 4) and a second region (30, 40) of a second conductivity type are embedded, the first and second regions being arranged next to one another and separately from one another and in each case at least one third (5) and fourth region (29) being embedded in the first and second region, respectively, the first region being connected to the first terminal and the second region being connected to the second terminal, the first region, the second region and that region of the semiconductor layer which lies between the first and second regions forming a parasitic MOS transistor, and **in that** the means prevents a threshold value of a voltage present between the first and second terminals from being reached, which would lead to an activation of the parasitic MOS transistor.

4. Component according to Claim 1, 2 or 3, **characterized in that** the first (3, 4) and the third (5) region and the semiconductor layer (2) form a parasitic bipolar transistor, the first region being short-circuited with the third region and forming the base of the parasitic bipolar transistor, and **in that** the means prevents an activation of the parasitic bipolar transistor.

5. Component according to Claim 3 or 4, **characterized in that** the protective element is turned off as long as the threshold value is not reached.

6. Component according to one of the preceding claims, **characterized in that** it is formed as a MOS component.

7. Component according to one of Claims 1 to 5, **characterized in that** it is formed as an IGBT component.

8. Component according to one of the preceding claims, **characterized in that** the means is monolithically integrated with the actuator and the measuring element.

9. Component according to one of the preceding claims, **characterized in that** it can be used without risk of failure for switching an inductive load, in particular as a high-side switch.

10. Component according to one of the preceding claims, **characterized in that** the means ensures an undisturbed operation of the measuring element as long as it is not activated.

## Revendications

1. Composant de puissance comprenant un actionneur (42) et un élément de mesure (41) voisin, qui sert d'élément capteur de courant pour la valeur du courant de charge dans l'actionneur, un premier contact source de l'actionneur et un deuxième contact source de l'élément de mesure, le premier contact source étant relié à la masse par une charge inductive (50), et un moyen (48) de protection contre les courants parasitaires connecté entre le premier et le deuxième contact source de telle sorte que dans le cas d'un potentiel négatif par rapport à la masse au niveau du premier contact source, le moyen est amené dans un état conducteur,
**caractérisé en ce que**
le moyen présente une diode Zener (48) dont l'anode est reliée au deuxième contact source et dont la cathode est reliée au premier contact source.

2. Composant de puissance comprenant un actionneur (42) et un élément de mesure (41) voisin qui sert d'élément capteur de courant pour la valeur du courant de charge passant à travers l'actionneur, un premier contact source de l'actionneur et un deuxième contact source de l'élément de mesure, le premier contact source étant relié à la masse par une charge inductive (50), et un moyen (48) de protection contre les courants parasitaires connecté entre le premier et le deuxième contact source, de telle sorte que dans le cas d'un potentiel négatif par rapport à la masse au niveau du premier contact source, le moyen est amené dans un état conducteur,
**caractérisé en ce que**
le moyen présente un circuit de protection (490) avec au moins une résistance (63), le choix de la valeur de résistance permettant de régler la condition de valeur du potentiel négatif au niveau du premier contact source pour l'activation du circuit de protection.

3. Composant selon la revendication 1 ou 2,
**caractérisé en ce qu'**
il présente une couche semi-conductrice (2) d'un premier type de conductivité qui loge une première (3, 4) et une deuxième zones (30, 40) d'un deuxième type de conductivité, la première et la deuxième zone étant voisines et séparées l'une de l'autre, alors qu'au moins une troisième (5) ou quatrième zone (29) est logée dans la première ou la deuxième zone, la première zone étant reliée au premier contact et la deuxième zone au deuxième contact, la première zone, la deuxième zone et la zone de la couche semi-conductrice située entre la première et la deuxième zone forment un transistor MOS (métal-oxyde-semiconducteur) parasitaire, et le moyen empêche une tension appliquée entre le premier et le deuxième contact d'atteindre une valeur de seuil qui conduirait à une activation du transistor MOS parasitaire.

4. Composant selon la revendication 1, 2 ou 3,
**caractérisé en ce que**
la première (3, 4) et la troisième (5) zone ainsi que la couche semi-conductrice (2) forment un transistor bipolaire parasitaire, la première zone étant en court-circuit avec la troisième zone et formant la base du transistor bipolaire parasitaire, et le moyen empêche une activation du transistor bipolaire parasitaire.

5. Composant selon la revendication 3 ou 4,
**caractérisé en ce que**
l'élément de protection est bloqué tant que la valeur de seuil n'est pas atteinte.

6. Composant selon l'une des revendications précédentes,
**caractérisé en ce qu'**
il est en forme de composant MOS.

7. Composant selon l'une des revendications 1 à 5,
**caractérisé en ce qu'**
il est en forme de composant transistor bipolaire à porte isolée.

8. Composant selon l'une des revendications précédentes,
**caractérisé en ce que**
le moyen est intégré en un seul bloc avec l'actionneur et l'élément de mesure.

9. Composant selon l'une des revendications précédentes,
**caractérisé en ce qu'**
il peut être utilisé sans danger de défaillance pour la connexion d'une charge inductive, en particulier en tant que commutateur haute puissance.

10. Composant selon l'une des revendications précédentes,
**caractérisé en ce que**
le moyen garantit un fonctionnement non perturbé de l'élément de mesure tant qu'il n'est pas activé.
